# EUROPÄISCHE PATENTSCHRIFT

(11) **EP 2 204 660 B1**
(45) Veröffentlichungstag und Bekanntmachung des Hinweises auf die Patenterteilung: **27.06.2018**
(21) Anmeldenummer: 08022578.2
(22) Anmeldetag: 30.12.2008
(51) Int. Cl.: G01R 31/12, H02H 1/00

(54) **VORRICHTUNG UND VERFAHREN ZUM BESTIMMEN VON TEILENTLADUNGEN AN EINER ELEKTRISCHEN KOMPONENTE**
METHOD AND DEVICE FOR DETERMINING PARTIAL DISCHARGES FROM AN ELECTRIC COMPONENT
DISPOSITIF ET PROCÉDÉ DE DÉTERMINATION DE DÉCHARGEMENTS PARTIELS SUR UN COMPOSANT ÉLECTRIQUE

(43) Veröffentlichungstag der Anmeldung: 07.07.2010
(73) Patentinhaber: Omicron electronics GmbH, 6833 Klaus (AT)
(72) Erfinder: Steineke, Caspar, 10625 Berlin (DE); Emanuel, Harald, 10553 Berlin (DE); Plath, Ronald, 10783 Berlin (DE)
(74) Vertreter: Banzer, Hans-Jörg

(56) Entgegenhaltungen:
- WO-A1-00/20878
- US-A- 4 063 168
- US-A- 5 602 709
- US-A- 5 933 012
- US-B1- 6 297 645
- US-B1- 6 377 427
- G.C. STONE: "Partial discharge diagnostics and electrical equipment insulation condition assessment", IEEE TRANSACTIONS ON DIELECTRICS AND ELECTRICAL INSULATION., vol. 12, no. 5, 1 October 2005 (2005-10-01), pages 891-903, XP055101396, US ISSN: 1070-9878, DOI: 10.1109/TDEI.2005.1522184
- BORGHETTO J ET AL: "Partial Discharge Inference by an Advanced System. Analysis of Online Measurements Performed on Hydrogenerator", IEEE TRANSACTIONS ON ENERGY CONVERSION, IEEE SERVICE CENTER, PISCATAWAY, NJ, US, vol. 19, no. 2, 1 June 2004 (2004-06-01), pages 333-339, XP011113368, ISSN: 0885-8969, DOI: 10.1109/TEC.2004.827473

## Beschreibung

Die vorliegende Erfindung betrifft ein Verfahren und eine Vorrichtung zum Bestimmen von Teilentladungen an einer elektrischen Komponente, welche insbesondere bei einer Durchführung von Teilentladungsmessungen von elektrischen Komponenten, wie z.B. Hochspannungskabeln, rotierenden Maschinen, Transformatoren oder dergleichen verwendet werden können.

Eine Teilentladungsmessung (TE-Messung) ist ein weltweit anerkanntes Verfahren zur Qualitätskontrolle sowohl im Labor als auch im Feld. Teilentladungen (TE) sind gemäß IEC 60270 als lokale dielektrische Durchschläge in einem kleinen Teil eines festen oder flüssigen elektrischen Isolationssystems bei hoher Spannungsbeanspruchung definiert. Teilentladungen deuten in vielen Fällen auf Isolationsfehler an Hochspannungskomponenten hin. Eine zuverlässige Erkennung und Überwachung von Teilentladungen schützt vor kostenintensiven Ausfällen und Reparaturen und ist daher von entscheidender Bedeutung. Die TE-Messung ist eines der Hauptkriterien bei der Beurteilung der Qualität eines Kabels oder einer Kabelgarnitur sowie deren Montage vor Ort.

In diesem Zusammenhang sind aus der US 5,602,709 ein Verfahren und eine Vorrichtung zum Erfassen von Hochimpedanzfehlern und weiteren Lichtbogenphänomenen in einem elektrischen Verteilungssystem bekannt. Elektrische Signale auf dem Verteilungssystem werden überwacht und eine Anzahl von Frequenzkomponenten isoliert und eine Messung einer Größe der Komponenten über aufeinanderfolgende Datenakquisitionsperioden durchgeführt. Die Messungen der Komponentengrößen werden für jede Datenakquisitionsperiode in ein Muster geformt und die Unterschiede zwischen Mustern für aufeinanderfolgende Perioden werden mit einem Musterschwellenwert verglichen. Eine Musterdifferenz größer als der Musterschwellenwert zeigt die Möglichkeit eines Lichtbogenfehlers an.

Die US 6,377,427 B1 betrifft eine Lichtbogenfehlerschutzanordnung in einem elektrischen Auslass. Die Anordnung umfasst einen Sensor, einen Breitbandrauschschaltkreis und eine Steuerung. Der Sensor erfasst einen Strom und bildet ein entsprechendes Sensorsignal. Der Breitbandrauschschaltkreis bestimmt das Vorhandensein von Breitbandrauschen in dem Sensorsignal und erzeugt ein entsprechendes Ausgangssignal. Der Breitbandrauschschaltkreis kann einen oder mehrere Bandpassfilterschaltkreise umfassen. Die Steuerung verarbeitet das Sensorsignal und das Ausgangssignal, um zu bestimmen, ob ein Lichtbogenfehler vorliegt.

Die US 4,063,168 betrifft ein Verfahren zum Lokalisieren der Quelle einer Koronarentladung. Es wurde festgestellt, dass eindeutige Entladesignaturwellenformen den Koronarentladungen der Komponenten von Energietrennungsfiltern von Repeatern und Equalizern zugeordnet sind. Diese Signaturwellenformen können gemessen und identifiziert werden, indem Koronarentladungen in die Hochspannungskomponenten induziert werden. Ein Entladesignal, welches als Antwort auf eine Koronarentladung über eine Hochspannungskomponente erzeugt wird, hat die gleiche Form wie eine der Signaturwellenformen. Somit kann eine Koronarentladung von einem zum testenden Repeater oder Equalizer durch Vergleichen seines Entladesignals mit dem Katalog von Signaturwellenformen lokalisiert werden. Die Beziehung zwischen den Spektralenergien des Entladesignals kann bei zwei vorbestimmten Frequenzen mit der Beziehung zwischen den Spektralenergien der Signaturwellenformen bei denselben Frequenzen verglichen werden. Aus einem derartigen Vergleich kann die ähnlichste Signaturwellenform bestimmt werden und somit die Quelle der Koronarentladung identifiziert werden.

Aus der US 6,297,645 B1 ist eine Vorrichtung zum Erfassen von Entladungen in einem Testobjekt mit zwei elektrischen Verbindungsleitern bekannt. Die Vorrichtung umfasst mindestens einen ersten und einen zweiten Sensor und eine Auswertungseinrichtung. Jeder der Sensoren erzeugt für die Auswertungseinrichtung Sensorsignale in Abhängigkeit von Strompulsen durch die Verbindungsleiter und der Richtung davon. Die Auswertungseinrichtung erzeugt in Abhängigkeit von den empfangenen Sensorsignalen ein Anzeigesignal, welches eine Teilentladung in dem Testobjekt anzeigt.

Aus der WO 00/20878 ist eine Erfassung von Zuständen von Motoren, und insbesondere das Erfassen von Bedingungen einer Motorverschmutzung bekannt, bei dem unter anderem ein Cluster-Verfahren eingesetzt wird, um normale Muster mit geringem Pegel zu erfassen.

Aus "Partial Discharge Inference by an Advanced System. Analysis of Online Measurements Performed on Hydrogenerator", Borghetto J; Cavallini A; Contin A; Montanari G C; Pasini G; Passaglia R; deNigris M, IEEE TRANSACTIONS ON ENERGY CONVERSION, 01.06.2004, ist ein Verfahren zur Trennung und Identifizierung von Teilentladungs-Quellen bekannt, wobei eine Cluster-Analyse für eine Zeit-Frequenz-Repräsentation von erfassten Pulsen durchgeführt wird.

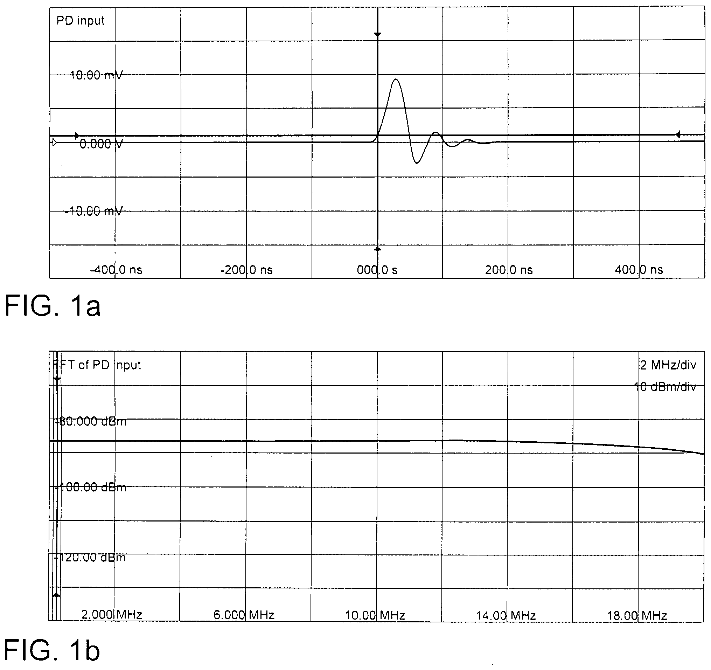

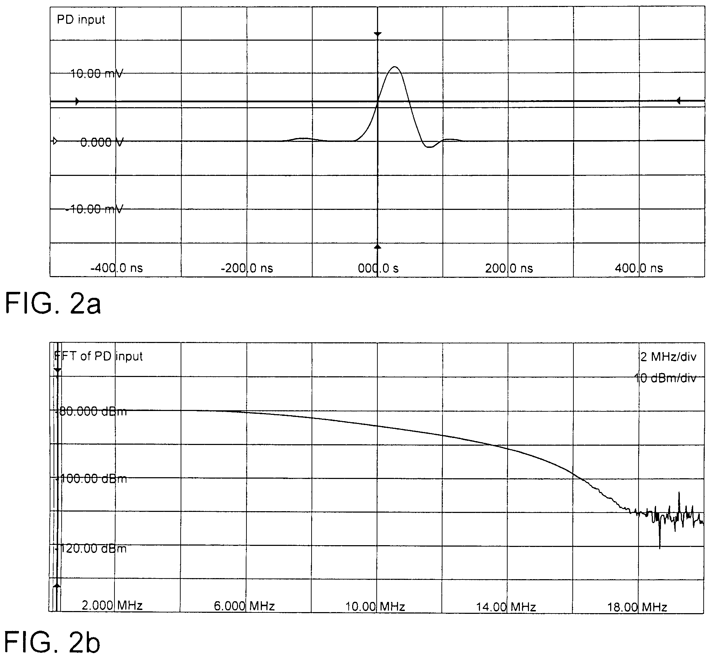

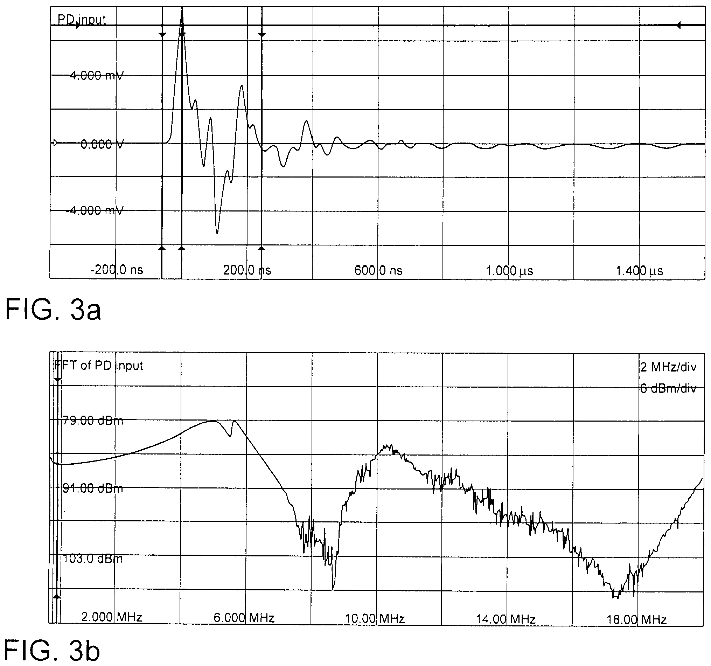

Aus "Partial discharge diagnostics and electrical equipment insulation condition assessment", Stone G C, IEEE TRANSACTIONS ON DIELECTRICS AND ELECTRICAL INSULATION, 2005 sind mehrere Verfahren zur Diagnose von Teilentladungen bekannt, unter anderem eine Zeit-Frequenz-Cluster-Analyse sowie eine "Fractal Analysis", worin ebenfalls identifizierbare Cluster generiert werden. Kabel selbst werden beispielsweise mit einer empfindlichen TE-Messung geprüft. Während der Herstellung werden die Kabel in einem abgeschirmten Labor geprüft. Dazu wird das Kabel mit einer Hochspannung, beispielsweise einer Betriebswechselspannung des Kabels, beaufschlagt und mit Hilfe einer Teilentladungsmessvorrichtung werden die Teilentladungen über einen vorbestimmten Zeitraum gemessen. Aufgrund der unterschiedlichen Ursachen der Teilentladungen, wie z.B. Lufteinschlüssen in der Isolierung, treten bei der angelegten Wechselspannung im Verlauf einer Periode der Wechselspannung Teilentladungen zu unterschiedlichen Zeiten auf. Jede Teilentladung bewirkt einen Stromimpuls oder Stromstoß, welcher mit Hilfe eines Koppelkondensators und einer Messimpedanz in einen entsprechenden Spannungsimpuls umgewandelt wird. Dieser Spannungsimpuls wird dann zum Bestimmen der Teilentladung weiterverarbeitet. Fig. 1a zeigt den Verlauf eines derartigen Spannungsimpulses im Zeitbereich und Fig. 1b das Frequenzspektrum des Spannungsimpulses der Fig. 1a. Der in Fig. 1 gezeigte Spannungsimpuls ist ein nahezu idealer Spannungsimpuls aus einer Teilentladungskalibriervorrichtung. Da die Teilentladung jedoch in einem Kabel oder einem vergleichbaren Prüfling, wie z.B. einer elektri-schen Maschine oder einem Transformator, auftritt und das Spannungssignal nur außerhalb des Prüflings gemessen werden kann, wird das Spannungssignal aufgrund der elektrischen Eigenschaften des Prüflings einer Tiefpassfilterung unterzogen bevor es gemessen werden kann. Fig. 2a zeigt ein tiefpassgefiltertes Spannungsimpulssignal und Fig. 2b das entsprechende Frequenzspektrum. Reale Prüflinge, wie z.B. Hochspannungskabel oder andere elektrische Maschinen, bewirken jedoch sehr komplexe Filterungen des Teilentladungssignals. Ein Beispiel eines realen Teilentladungssignals von einem realen Prüfling ist in Fig. 3a dargestellt und Fig. 3b zeigt das entsprechende Frequenzspektrum des Teilentladungssignals.

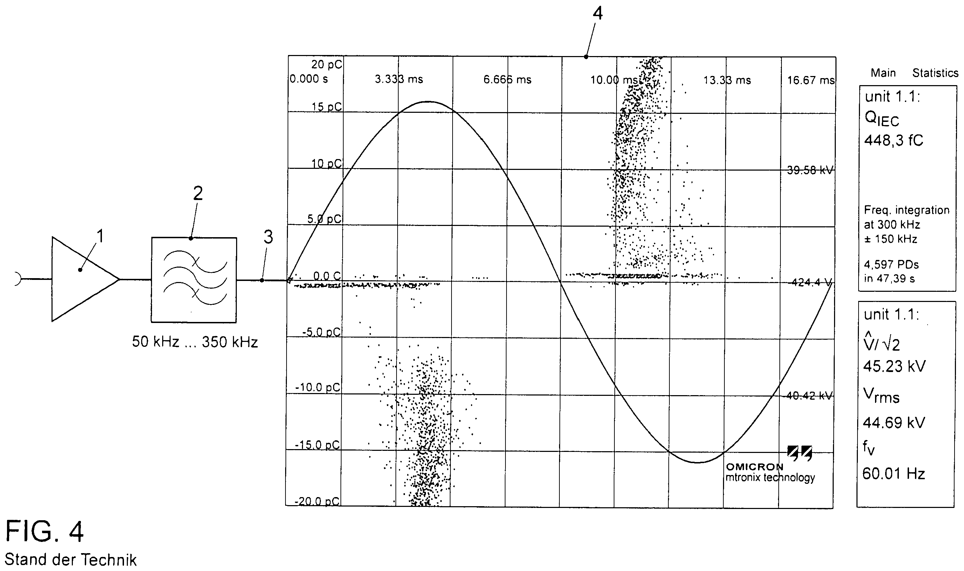

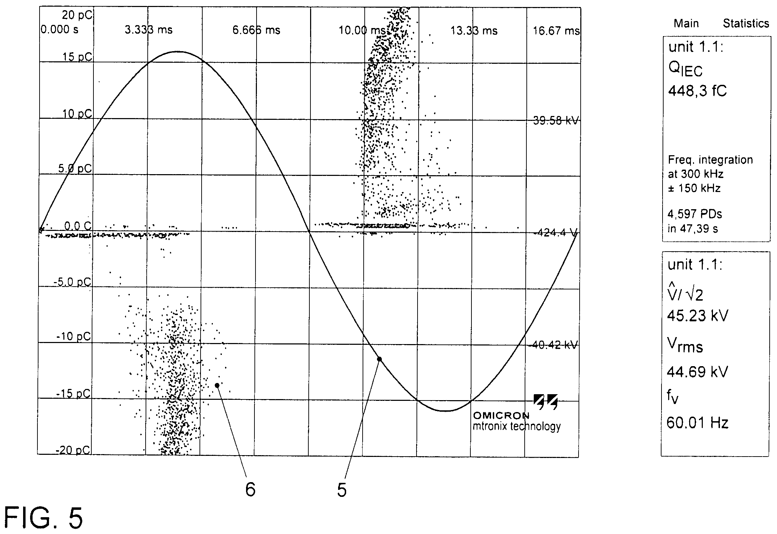

Wie zuvor erwähnt können die Teilentladungen in dem Prüfling beispielsweise mit Hilfe eines Koppelkondensators und einer Messimpedanz in ein entsprechendes Spannungssignal umgewandelt werden. Zur Bestimmung der Teilentladung des Prüflings wird dieses Spannungssignal, wie in Fig. 4 gezeigt, mit Hilfe eines Verstärkers 1 verstärkt und mit Hilfe eines Bandpassfilters 2 gefiltert. Das Filter weist üblicherweise eine variable obere und untere Grenzfrequenz auf. Das Filtern wird üblicherweise auf ein Frequenzband mit niedrigem Störpegel eingestellt, in dem sich der breitbandige Teilentladungsimpuls klar vom Hintergrundrauschen abhebt. Das Filter kann beispielsweise ein Bandpassfilter mit einem Durchlassbereich von 50 bis 350 kHz sein. Die Tiefpasseigenschaft des Filters sorgt für eine Integration des Impulsverlaufs, so dass sich am Filterausgang ein ladungsproportionales Signal 3 ergibt. Das ladungsproportionale Signale 3 wird einer Verarbeitungseinheit 4 zugeführt, welche die ladungsproportionalen Signale, welche sich in einem vorbestimmten Zeitraum aufgrund von mehreren Teilentladungen ergeben, sammelt und beispielsweise in der in Fig. 4 dargestellten Art und Weise über der an den Prüfling angelegten Spannung darstellt. Fig. 5 zeigt diese Darstellung im Detail. Ein kompletter Phasenzyklus der an den Prüfling angelegten Spannung ist als Graph 5 über der Zeit dargestellt. Im vorliegenden Beispiel hat die an den Prüfling angelegte Wechselspannung eine Frequenz von ungefähr 60 Hz, so dass ein kompletter Zyklus ungefähr 16,67 ms beträgt. Der Prüfling wird für eine vorbestimmte Zeit, im vorliegenden Beispiel für 47,39 s, mit der durch den Graphen 5 angegebenen Prüfspannung beaufschlagt. In dem Prüfzeitraum treten sehr viele Teilentladungen auf, welche jeweils als ein Punkt 6 in dem in Fig. 5 dargestellten Diagramm aufgetragen werden. Eine Teilentladung wird bezüglich ihrer Phasenlage zu der Prüfspannung 5 und ihrer Ladungsgröße in dem Diagramm eingetragen. Gibt es an einer Stelle in dem Diagramm eine größere Häufung von Punkten 6 so kann diese Häufung beispielsweise durch Verwenden einer anderen Farbe für die Punkte 6 in Abhängigkeit der Häufigkeit gekennzeichnet werden.

Anhand von Phasenlage, Ladungsgröße, Ladungsvorzeichen und Häufigkeit kann auf eine Ursache der Teilentladungen geschlossen werden. Schließlich wird von der Verarbeitungseinheit 4 eine Gesamtladung der Teilentladungen über den vorbestimmten Zeitraum ermittelt, welche die Qualität des Prüflings, beispielsweise eines Hochspannungskabels vorbestimmter Länge, angibt.

Bei dem zuvor beschriebenen Verfahren zur Bestimmung der Teilentladungen in einem Prüfling können verschiedene Probleme auftreten, welche das Teilentladungsmessergebnis verfälschen können. Beispielsweise können externe Störgrößen, wie z.B. elektromagnetische Funkwellen, Signale in dem Prüfling erzeugen, welche fälschlicherweise als Teilentladungsimpuls gewertet werden. Üblicherweise wird versucht derartige Störquellen zu beseitigen, indem der Prüfling und die Messvorrichtung in einem abgeschirmten Raum betrieben werden. Dies ist jedoch insbesondere bei großen Prüflingen, wie z.B. elektrischen Maschinen oder Transformatoren, sehr aufwändig. Weiterhin wird versucht derartige Störungen durch Verwenden eines geeigneten Filters 2 zu vermeiden. Dabei besteht jedoch die Gefahr, dass neben den Störsignalen auch tatsächliche Teilentladungssignale herausgefiltert werden.

Ein weiteres Problem bei der Teilentladungsmessung ist die Trennung mehrerer überlagerter Teilentladungsquellen voneinander. Bei der Überlagerung mehrerer Teilentladungsquellen und/oder stochastischer impulshafter Störer ergibt sich am Ausgang des Filters 2 ein überlagertes Signal bzw. Impulsgemisch, welches keine präzise Aussage über die Natur und Intensität einzelner Teilentladungsquellen im untersuchten Prüfling gestattet. Dadurch kann die Aussagequalität des Teilentladungsmessergebnisses herabgesetzt werden. Ein weiteres spezielles Problem bei der Teilentladungsmessung, insbesondere an Kabeln, ist die so genannte negative Superposition. Dabei kommt es zu einer Überlagerung eines Originalteilentladungsimpulses mit einem am Kabelende reflektierten Teilentladungsimpuls. Bei bestimmten Kabellängen führt dies in Kombination mit Filtereigenschwingungen und/oder Nullstellen des Bandpassfilters 2 zu einer negativen Überlagerung oder sogar Auslöschung, in deren Folge ein Teilentladungsfehler am Kabel übersehen werden kann. Um ein derartiges negatives Superpositionsverhalten auszuschließen, werden Teilentladungsmesseinrichtungen üblicherweise von Doppelimpulskalibratoren geprüft. Dabei werden zwei aufeinanderfolgende Impulse definierter Ladung mit variablem und definiertem Abstand in das Messsystem eingegeben, wobei der Anzeigewert nur um weniger als 10% vom Ladungswert des Impulses nach unten abweichen darf.

Dies erfordert aufwändige Bandpassfilter 2, die diese Tests bestehen, und führt gegebenenfalls zu Bandpassbeschränkungen des Bandpassfilters 2.

Der vorliegenden Erfindung liegt daher die Aufgabe zu Grunde, eine Vorrichtung sowie ein Verfahren zum Bestimmen von Teilentladungen an einer elektrischen Komponente bereitzustellen, womit die zuvor erwähnten Probleme beseitigt werden können. Insbesondere liegt der Erfindung die Aufgabe zu Grunde, eine Vorrichtung sowie ein Verfahren zum Bestimmen von Teilentladungen an einer elektrischen Komponente, wie z.B. Transformatoren, rotierenden Maschinen oder Kabeln, bereitzustellen, welche eine kostengünstige und zuverlässige Teilentladungsmessung ermöglicht.

Diese Aufgabe wird erfindungsgemäß durch ein Verfahren zum Bestimmen von Teilentladungen an einer elektrischen Komponente nach Anspruch 1 bzw. eine Vorrichtung zum Bestimmen von Teilentladungen an einer elektrischen Komponente nach Anspruch 8 gelöst. Die abhängigen Ansprüche definieren jeweils bevorzugte und vorteilhafte Ausführungsformen der vorliegenden Erfindung.

Gemäß der vorliegenden Erfindung wird ein Verfahren zum Bestimmen von Teilentladungen in einem elektrischen Isolationssystem einer elektrischen Komponente bereitgestellt. Die elektrische Komponente kann beispielsweise ein Hochspannungskabel, ein Transformator, ein elektrischer Generator, eine elektrische Antriebsmaschine oder dergleichen sein. Insbesondere kann die elektrische Komponente eine elektrische Komponente sein, welche für einen Betrieb mit einer Mittelspannung oder einer Hochspannung, d.h. einer Spannung mit einigen kV, geeignet ist. Bei dem Verfahren wird ein elektrisches Signal erfasst, welches Teilentladungsimpulse aufgrund von dielektrischen Durchschlägen in dem elektrischen Isolationssystem der elektrischen Komponente umfasst. Das elektrische Signal kann beispielsweise, wie zuvor in der Einleitung beschrieben, mit Hilfe eines Koppelkondensators und einer Messimpedanz erfasst werden. Das erfasste elektrische Signal wird dann mehreren Filtern mit unterschiedlichen Filtercharakteristiken zugeführt. Jedes der mehreren Filter erzeugt aus dem elektrischen Signal jeweils ein gefiltertes Teilentladungssignal. Die Anzahl der Filter beträgt mindestens zwei. Somit werden mindestens zwei gefilterte Teilentladungssignale erzeugt. Die Teilentladungen an der elektrischen Komponente werden dann durch Verknüpfen der mehreren gefilterten Teilentladungssignale bestimmt.

Weiterhin wird pro Teilentladungsimpuls ein n-Tupel gebildet, wobei Werte des n-Tupels den n mehreren gefilterten Teilentladungssignalen des Teilentladungsimpulses entsprechen. Mehrere n-Tupel von mehreren Teilentladungsimpulsen werden dann mit Hilfe einer Clusteranalyse weiterverarbeitet. Werden beispielsweise für jeden Teilentladungsimpuls mit Hilfe von n Filtern n gefilterte Teilentladungssignale erzeugt und in ein entsprechendes n-Tupel eingetragen, so kann dieses n-Tupel in einem n-dimensionalen Abbildungsraum eingetragen werden. Werden mehrere n-Tupel von mehreren Teilentladungsimpulsen in dem n-dimensionalen Abbildungsraum eingetragen, so können Häufungen an bestimmten Stellen in dem Abbildungsraum mit Hilfe einer Clusteranalyse festgestellt werden. Aufgrund der Lage der Cluster der Clusteranalyse kann dann beispielsweise eine Teilentladungsquelle, welche eine Teilentladung in der elektrischen Komponenten bewirkt, identifiziert werden. Auch eine Kombination von verschiedenen Clustern der Clusteranalyse können zum Identifizieren einer derartigen Teilentladungsquelle verwendet werden. Ein oder mehrere Cluster stellen somit eine Art Signatur eines Teilentladungsphänomens dar, welches als eine oder mehrere Teilentladungen von einer Teilentladungsquelle bewirkt wird. Indem jede Teilentladung mit Hilfe der n Filter mit den n unterschiedlichen Filtercharakteristiken gefiltert wird, kann diese Teilentladungssignatur auf einfache Art und Weise in dem Abbildungsraum der Clusteranalyse identifiziert werden. Dadurch ist eine einfache Identifizierung von Teilentladungsquellen, d.h. Ursachen von Teilentladungen in der elektrischen Komponente, möglich.

Gemäß einer weiteren Ausführungsform können anhand eines Clusters oder mehrerer Cluster der Clusteranalyse Störquellen identifiziert werden, welche Störsignale in das elektrische Signal einspeisen. Derartige Störquellen können beispielsweise elektromagnetische Hochfrequenzsignale sein, welche in die elektrische Komponente eindringen und dort Störsignale erzeugen, welche über das elektrische Signal ähnlich wie die Teilentladungen Signalimpulse erzeugen. Diese Signalimpulse verlaufen ebenfalls durch die n Filter und werden wie zuvor beschrieben als n-Tupel in dem Abbildungsraum der Clusteranalyse wiedergegeben. Anhand der Signatur der Störquelle, d.h. anhand der Lage von einem oder mehreren Clustern der Clusteranalyse kann ein derartiges Störsignal und somit eine derartige Störquelle identifiziert werden. Zum Bestimmen der Teilentladungen an der elektrischen Komponente werden dann nur diejenigen gefilterten Teilentladungssignale verwendet, welche nicht von der Störquelle erzeugt wurden. Dadurch können die Teilentladungen an der elektrischen Komponente erheblich genauer bestimmt werden, da Störsignale von Störquellen mit Hilfe der Clusteranalyse auf einfache Art und Weise identifiziert und von der Bestimmung der Teilentladungen ausgeschlossen werden können.

Gemäß einer weiteren Ausführungsform der vorliegenden Erfindung wird für jedes der n gefilterten Teilentladungssignale jeweils ein Betrag bestimmt und die Beträge der n gefilterten Teilentladungssignale gewichtet addiert. Das Bestimmen des Betrags von einem gefilterten Teilentladungssignale kann beispielsweise ein Quadrieren des gefilterten Teilentladungssignals umfassen. Beispielsweise können drei gefilterte Teilentladungssignale durch Filtern des elektrischen Signals mit drei Filtern mit drei unterschiedlichen Filtercharakteristiken erzeugt werden. Ein erstes der drei Filter kann beispielsweise ein Bandpassfilter mit einem Durchlassbereich von ca. 82 bis 243 kHz sein, ein zweites der drei Filter kann ein Bandpassfilter mit einem Durchlassbereich von ca. 227 bis 387 kHz sein und ein drittes der drei Filter kann ein Bandpassfilter mit einem Durchlassbereich von ca. 377 bis 537 kHz sein. Als Gewichtungsfaktoren zum gewichteten Addieren der Beträge der drei gefilterten Teilentladungssignale können beispielsweise folgende Werte verwendet werden. Das von dem ersten Filter gefilterte Teilentladungssignal kann mit dem Wert 1 gewichtet werden, das von dem zweiten Filter gefilterte Teilentladungssignal mit dem Wert 1,1 und das von dem dritten Filter gefilterte Teilentladungssignal mit dem Wert 1. Nach dem gewichteten Addieren ergibt sich ein Teilentladungssignal ähnlich zu dem gefilterten Teilentladungssignal 3 gemäß dem Stand der Technik, welches mit Hilfe des Bandpassfilters 2, wie im Zusammenhang mit Fig. 4 beschrieben, erzeugt wird. Vorteil des erfindungsgemäßen Teilentladungssignals, welches aus der gewichteten Addition gebildet wird, gegenüber dem Teilentladungssignal 3 aus dem Stand der Technik ist, dass das erfindungsgemäße Teilentladungssignal das Problem der zuvor beschriebenen Superposition, insbesondere der negativen Superposition, vermeidet, da das erfindungsgemäße Teilentladungssignal aus einer Kombination mehrerer bandpassgefilterter Teilentladungssignale gebildet wird, wodurch die Schwächen von praktischen Filtern, wie z.B. Filtereigenschwingungen und Nullstellen durch die unterschiedlichen Filtercharakteristiken der mehreren Bandpassfilter umgangen werden. Während bei dem Bandpassfilter gemäß dem Stand der Technik bei bestimmten Impulskombinationen negative Überlagerungen oder sogar Auslöschungen auftreten können, können derartige Überlagerungen oder Auslöschungen eines speziellen Teilentladungsimpulses bei der erfindungsgemäßen Filterstruktur immer nur an einem der mehreren Bandpassfilter auftreten, wohingegen die übrigen der mehreren Bandpassfilter bezüglich Überlagerung oder Auslöschung gegenüber dem speziellen Teilentladungsimpuls robust sind. In dem Summensignal kann somit eine Überlagerung oder Auslöschung zuverlässig verringert werden. In der Praxis hat sich gezeigt, dass mit drei Filtern mit den zuvor genannten Durchlassbereichen und den zuvor genannten Gewichtungsfaktoren besonders zuverlässige Teilentladungsmessungen durchgeführt werden konnten.

Gemäß der vorliegenden Erfindung wird weiterhin eine Vorrichtung zum Bestimmen von Teilentladungen in einem elektrischen Isolationssystem einer elektrischen Komponente bereitgestellt. Die Vorrichtung umfasst einen Eingangsanschluss zum Koppeln der Vorrichtung mit der elektrischen Komponente, n Filter und eine Verarbeitungseinheit. Über den Eingangsanschluss ist der Vorrichtung ein elektrisches Signal von der elektrischen Komponente, wie z.B. einem Hochspannungskabel, einem Transformator, einem elektrischen Generator oder einer elektrischen Antriebsmaschine, zuführbar. Das elektrische Signal umfasst Teilentladungsimpulse, welche aufgrund von dielektrischen Druchschlägen in dem Isolationssystem der elektrischen Komponente auftreten. Die n Filter sind jeweils eingangsseitig mit dem Eingangsanschluss gekoppelt. Die n Filter sind jeweils derart ausgestattet, dass sie ausgangsseitig gefilterte Teilentladungssignale in Abhängigkeit des elektrischen Signals bereitstellen. Somit werden n gefilterte Teilentladungssignale an den n Ausgängen der n Filter bereitgestellt. Die n Filter weisen n unterschiedliche Filtercharakteristiken auf. Die Vorrichtung umfasst mindestens zwei Filter, d.h. n ≥ 2. Die Verarbeitungseinheit ist mit den Ausgängen der n Filter gekoppelt und derart ausgestaltet, dass sie die Teilentladungen durch Verknüpfen der n gefilterten Teilentladungssignale bestimmt.
Weiterhin bildet die Verarbeitungseinheit für jeden Teilentladungsimpuls ein n-Tupel, wobei die n Werte des n-Tupels den n gefilterten Teilentladungssignalen des Teilentladungsimpulses entsprechen. Eine gefiltertes Teilentladungssignal kann beispielsweise ein ladungsproportionales Signal des Teilentladungsimpulses in Abhängigkeit der Filtercharakteristik des entsprechenden Filters umfassen. Die Verarbeitungseinheit umfasst eine Clusteranalyseeinheit, welche Cluster oder Häufungen von Teilentladungsimpulsen mit Hilfe einer Clusteranalyse von mehreren n-Tupeln von mehreren Teilentladungsimpulses bestimmt. Dazu kann die Clusteranalyseeinheit ein n-Tupel in einen n-dimensionalen Abbildungsraum eintragen, wobei ein n-Tupel einen Punkt in dem n-dimensionalen Abbildungsraum bezeichnet, wobei jeder der n Werte des n-Tupels jeweils einer Dimension des n-dimensionalen Raums zugeordnet wird. Werden hinreichend viele Teilentladungsimpulse erfasst und ihre entsprechenden n-Tupel in den n-dimensionalen Abbildungsraum eingetragen, so können Häufungen von Teilentladungsimpulsen in Bereichen des Abbildungsraums mit Hilfe der Clusteranalyse bestimmt werden. Aufgrund der Lage der Cluster in dem Abbildungsraum kann die Verarbeitungseinheit Ursachen, so genannte Teilentladungsquellen, welche ein Teilentladungsphänomen an der elektrischen Komponente bewirken, identifizieren. Teilentladungsquellen können beispielsweise durch die Lage eines Clusters oder durch die Lage mehrerer Cluster identifiziert werden. Dadurch ist nicht nur eine Bestimmung der Teilentladungen an der elektrischen Komponente möglich, sondern darüber hinaus auch eine Bestimmung von Teilentladungsquellen, welche die Teilentladungen bewirken, möglich.

Mit Hilfe der Cluster der Clusteranalyse kann die Verarbeitungseinheit weiterhin Störquellen identifizieren. Eine Störquelle bewirkt, dass in dem elektrischen Signal Störsignale vorhanden sind, welche ähnlich wie die Teilentladungen hinter den n Filtern Signale erzeugen, welche ähnlich zu den gefilterten Teilentladungssignalen sind. Störsignale von typischen Störquellen, wie z.B. Hochfrequenzfunksendern, können dann mit Hilfe der Clusteranalyse identifiziert werden, da diese Störsignale in dem Abbildungsraum ebenso wie die Teilentladungen charakteristische Cluster oder Häufungen bilden. Somit können auf einfache Art und Weise Störsignale identifiziert werden und diese können bei der Bestimmung der Teilentladungen von der Verarbeitungseinheit unberücksichtigt bleiben.

Gemäß einer Ausführungsform ist die Verarbeitungseinheit derart ausgestaltet, dass sie Beträge der n gefilterten Teilentladungssignale bestimmt und diese n Beträge jeweils mit einem eigenen Gewichtungsfaktor multipliziert. Das Bestimmen eines Betrags kann beispielsweise durch quadrieren des entsprechenden gefilterten Teilentladungssignals bestimmt werden. Weiterhin ist die Verarbeitungseinheit ausgestaltet, die gewichteten Beträge zu summieren, um daraus den Betrag einer Teilentladung der elektrischen Komponente zu bestimmen. Wie zuvor im Zusammenhang mit dem erfindungsgemäßen Verfahren beschrieben, kann durch Verwenden der mehreren Filter und Zusammenführen der gefilterten Teilentladungssignale ein Betrag einer Teilentladung bestimmt werden, welcher nicht durch Superposition, insbesondere negative Superposition an Hochspannungskabeln, verfälscht wird.

Gemäß einer Ausführungsform werden drei Filter verwendet, d.h. n=3. Ein erstes der drei Filter kann beispielsweise ein Bandpassfilter mit einem Durchlassbereich von ca. 82-243 kHz sein, ein zweites der drei Filter kann ein Bandpassfilter mit einem Durchlassbereich von ca. 227-387 kHz sein und ein drittes der drei Filter kann ein Bandpassfilter mit einem Durchlassbereich von ca. 377-537 kHz sein. Die Gewichtungsfaktoren werden beispielsweise folgendermaßen eingestellt: ein erster Gewichtungsfaktor zum gewichteten Addieren des von dem ersten Filter gefilterten Teilentladungssignals hat den Wert 1, ein zweiter Gewichtungsfaktor zum gewichteten Addieren des von dem zweiten Filter gefilterten Teilentladungssignals hat den Wert 1,1 und ein dritter Gewichtungsfaktor zum gewichteten Addieren des von dem dritten Filter gefilterten Teilentladungssignals hat den Wert 1. Die so definierte Filterstruktur weist einen Durchlassbereich von ca. 82-537 kHz auf und ist gleichzeitig robust gegenüber einer Superposition, insbesondere einer negativen Superposition, welche durch Filtereigenschwingungen und/oder Nullstellen im Filter bewirkt wird. Dadurch kann eine Auslöschung oder Abschwächung von zwei schnell aufeinander folgenden Teilentladungssignalimpulsen, wie sie z.B. von einem Originalimpuls und einem am Kabelende reflektierten Impuls stammen können, zuverlässig vermieden werden.

Die vorliegende Erfindung wird nachfolgend unter Bezugnahme auf die Zeichnungen anhand bevorzugter Ausführungsformen erläutert werden.
Fig. 1 zeigt einen idealen Teilentladungsimpuls im Zeit- und Frequenzbereich.
Fig. 2 zeigt einen tiefpassgefilterten Teilentladungsimpuls im Zeit- und Frequenzbereich.
Fig. 3 zeigt einen realen Teilentladungsimpuls im Zeit- und Frequenzbereich.
Fig. 4 zeigt eine Vorrichtung zum Bestimmen von Teilentladungen gemäß dem Stand der Technik.
Fig. 5 zeigt eine Ausgabe einer Vorrichtung zum Bestimmen von Teilentladungen an einer elektrischen Komponente.
Fig. 6 zeigt schematisch eine Vorrichtung zum Bestimmen von Teilentladungen an einer elektrischen Komponente gemäß der vorliegenden Erfindung, welche an die elektrische Komponente gekoppelt ist.
Fig. 7 zeigt schematisch das Verfahren zum Bestimmen von Teilentladungen an einer elektrischen Komponente mit Hilfe einer Clusteranalyse gemäß der vorliegenden Erfindung.
Fig. 8 zeigt eine Darstellung eines dreidimensionalen Abbildungsraums der Clusteranalyse der Fig. 7.
Fig. 9 zeigt schematisch ein Verfahren gemäß der vorliegenden Erfindung zum Bestimmen von Teilentladungen an einer elektrischen Komponente, bei dem gefilterte Teilentladungssignale gewichtet addiert werden.

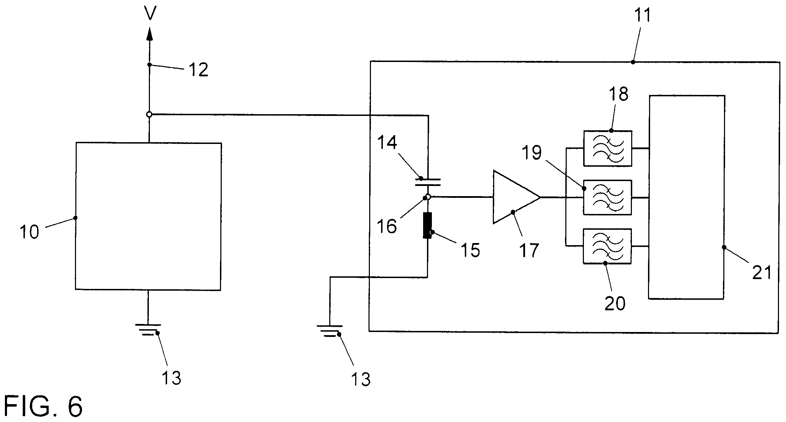

Fig. 6 zeigt eine elektrische Komponente 10 und eine Teilentladungsmessvorrichtung 11 zum Bestimmen von Teilentladungen an der elektrischen Komponente 10. Die elektrische Komponente 10 kann beispielsweise eine elektrische Maschine, wie z.B. ein elektrischer Generator oder ein elektrischer Motor, ein Transformator oder ein Kabel sein. Teilentladungsmessungen werden üblicherweise an elektrischen Komponenten durchgeführt, welche für einen Betrieb im Mittelspannungs- oder Hochspannungsbereich, d.h. mit Spannungen von einigen kV betrieben werden. Die elektrische Komponente 10 ist über einer Verbindung 12 mit einer entsprechenden Mittelspannungs- oder Hochspannungsquelle V, üblicherweise einer Wechselspannungsquelle, verbunden. Weiterhin ist ein Gehäuse oder eine Schirmung der elektrischen Komponente 10 mit Masse 13 verbunden. Die elektrische Komponente 10 wird nachfolgend auch als Prüfling 10 bezeichnet.

Treten im Betrieb oder bei einer Teilentladungsmessung im Labor des Prüflings 10 Teilentladungen an dem Prüfling 10 auf, so findet ein Ladungsaustausch zwischen der Versorgungsspannung V und Masse 13 statt. Dieser Ladungsaustausch kann beispielsweise mit Hilfe einer Reihenschaltung eines so genannten Koppelkondensators 14 und einer Messimpedanz 15, welche parallel zu dem Prüfling zwischen der Versorgungsspannung V und Masse 13 geschaltet sind, in eine Teilentladungsspannung umgewandelt werden, welche an einem Messpunkt 16 zwischen dem Koppelkondensator 14 und der Messimpedanz 15 abgegriffen werden kann. Die Messimpedanz 15 kann beispielsweise ein Widerstand, eine Spule oder eine Kombination daraus umfassen. Ein Spannungssignal, welches an dem Messpunkt 16 aufgrund einer Teilentladung in dem Prüfling 10 hervorgerufen wurde, ist beispielhaft in Fig. 3a dargestellt. Fig. 3b zeigt das Spektrum dieses Signals. Das Integral über dieses Signal ist proportional zur Ladung der Teilentladung in dem Prüfling 10. Dieser an dem Messpunkt 16 gemessene Teilentladungsimpuls wird mit Hilfe eines Verstärkers 17 der Teilentladungsmessvorrichtung 11 verstärkt und drei Bandpassfiltern 18-20 der Teilentladungsmessvorrichtung 11 zugeführt. Jedes der Bandpassfilter 18-20 hat einen anderen Durchlassbereich, so hat beispielsweise das Bandpassfilter 18 einen Durchlassbereich von 82,5-242,5 kHz, das Bandpassfilter 19 einen Durchlassbereich von 227-387 kHz und das Bandpassfilter 20 einen Durchlassbereich von 377-537 kHz. Die Ausgaben der Bandpassfilter 18-20, welche im Folgenden gefilterte Teilentladungssignale genannt werden, werden einer Verarbeitungseinheit 21 der Teilentladungsmessvorrichtung 11 zugeführt. Durch die Bandpassfilterung der Filter 18-20 werden Störsignale am Messpunkt 16 herausgefiltert. Dies können beispielsweise leitungsgebundene Störquellen sein, welche Signale im Bereich von 0 bis einigen wenigen kHz erzeugen. Darüber hinaus können dies Störquellen sein, welche Hochfrequenzsignale im Bereich von einigen MHz erzeugen. Darüber hinaus bewirkt die Tiefpassfilterung der Tiefpassfilter 18-20, dass die Teilentladungsimpulse integriert werden, so dass am Ausgang eines jeden Filters ein Wert bereitsteht, welcher proportional zur Ladung der Teilentladung ist.

Wie bereits in der Einleitung im Zusammenhang mit der Teilentladungsmessvorrichtung gemäß dem Stand der Technik (Fig. 4) beschrieben wurde, wird eine Teilentladungsmessung über einen vorbestimmten Zeitraum durchgeführt. Während dieses vorbestimmten Zeitraums treten eine Vielzahl von Teilentladungen, beispielsweise mehrere tausend Teilentladungen, auf. Da die Anregung des Prüflings 10 periodisch ist, beispielsweise mit Hilfe einer Wechselspannung von 50 oder 60 Hz, treten Teilentladungen aufgrund einer Störquelle in dem Prüfling, wie z.B. einer Isolationsluftblase oder dergleichen, während des Messzeitraums von beispielsweise einigen zig Sekunden, wiederholt mit ähnlicher Intensität auf. Fig. 5 zeigt eine Darstellung der Teilentladungsereignisse unter Berücksichtigung der Phasenlage der Teilentladungen zu der angelegten Wechselspannung und der Größe der Teilentladung.

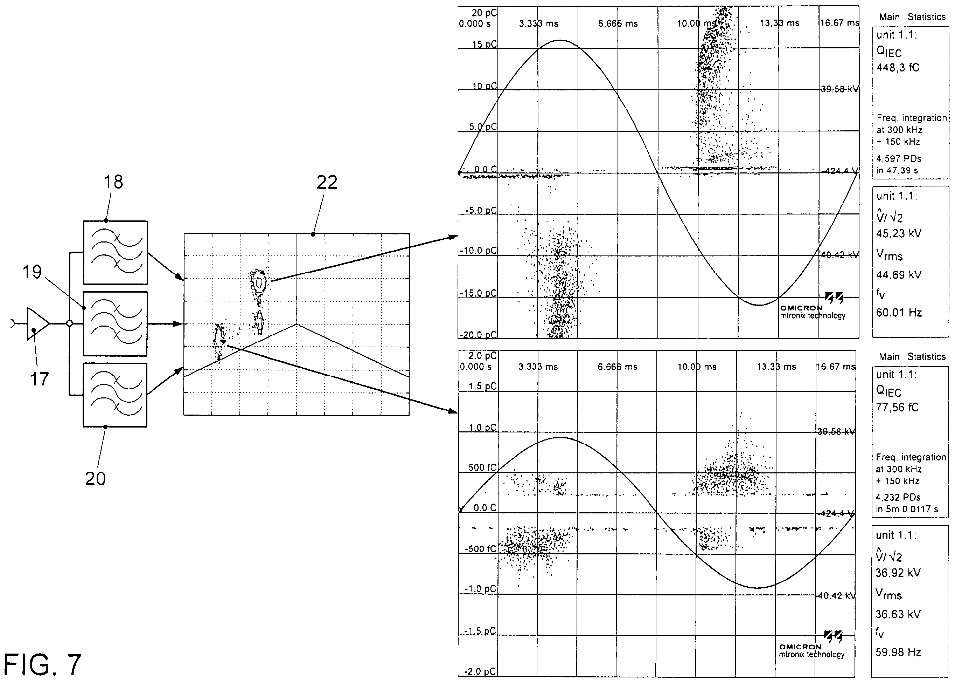

Jeder Teilentladungsimpuls hat ein sehr breites Frequenzspektrum, wie im Zusammenhang mit Fig. 1-3 bereits beschrieben wurde. Insbesondere hat jeder Teilentladungsimpuls auch Impulsanteile in den Frequenzspektren, welche als Durchlassfrequenzen der Filter 18-20 definiert sind. Somit bewirkt jeder Teilentladungsimpuls an jedem der Filter 18-20 eine Signalausgabe. Je nach Art und Lage der Teilentladungsquelle ergeben sich jedoch unterschiedliche gefilterte Teilentladungssignale an den Ausgängen der Filter 18-20. So kann beispielsweise eine Teilentladungsquelle ein großes Signal am Ausgang des Filters 18 bewirken und ein kleines Signal an den Ausgängen der Filter 19 und 20. Eine weitere Teilentladungsquelle kann hingegen an dem Ausgang des Filters 19 ein großes Signal bewirken, wohingegen an den Ausgängen der Filter 18 und 20 nur ein kleines Signal bewirkt wird. Somit hat jede Teilentladungsquelle eine eigene Signatur, eine so genannte Frequenzsignatur, welche durch die drei Werte der Filter 18-20 beschrieben wird. Diese Frequenzsignatur kann, wie im Zusammenhang mit Fig. 7 beschrieben werden wird, dazu verwendet werden, eine Clusteranalyse der gefilterten Teilentladungssignale durchzuführen und somit Teilentladungsquellen zu identifizieren.

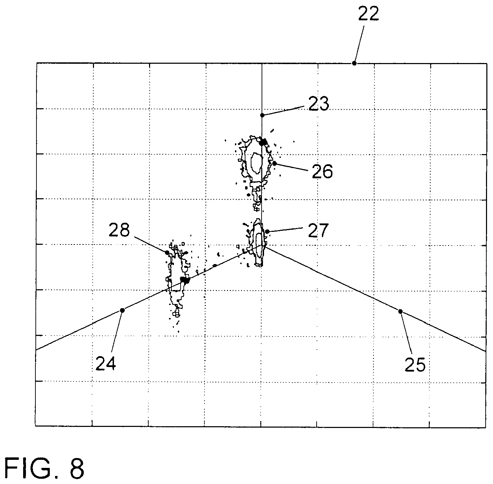

Fig. 7 zeigt schematisch das Verfahren dieser Clusteranalyse. Wie im Zusammenhang mit Fig. 6 beschrieben, wird das Messsignal mit Hilfe des Verstärkers 17 verstärkt und über die drei Filter 18-20 geführt. In der Verarbeitungseinheit 21 wird dann eine Clusteranalyse durchgeführt, welche in einem dreidimensionalen Abbildungsraum 22 die Teilentladungsimpulse anhand der drei gefilterten Teilentladungssignale der Filter 18-20 einträgt. Fig. 8 zeigt eine vergrößerte Darstellung des dreidimensionalen Abbildungsraums 22 mit den drei Raumachsen 23-25. Jedes Teilentladungssignal wird gemäß der gefilterten Teilentladungssignalwerte der Filter 18-20 in den Abbildungsraum 22 eingetragen. Der gefilterte Teilentladungssignalwert des Filters 18 wird auf der Raumachse 23 aufgetragen, der gefilterte Teilentladungssignalwert des Filters 19 wird auf der Raumachse 24 aufgetragen und der gefilterte Teilentladungssignalwert des Filters 20 wird auf der Raumachse 25 aufgetragen. Auf diese Art und Weise werden mehrere tausend Teilentladungen in den Abbildungsraum 22 eingetragen. Aufgrund der unterschiedlichen Frequenzsignaturen der unterschiedlichen Teilentladungsquellen des Prüflings 10 ergeben sich Teilentladungshäufungen in bestimmten Bereichen des Abbildungsraums 22. In Fig. 8 sind drei derartige Häufungen, so genannte Cluster, dargestellt. Teilentladungen, welche im Bereich des Clusters 26 dargestellt sind, haben ein großes gefiltertes Teilentladungssignal am Ausgang des Filters 18 und verhältnismäßig kleine Teilentladungssignale an den Ausgängen der Filter 19 und 20 bewirkt. Teilentladungen im Bereich des Clusters 28 haben hingegen große gefilterte Teilentladungssignale am Ausgang des Filters 19 und kleine Teilentladungssignale an den Ausgängen der Filter 18 und 20 bewirkt. Aufgrund dieser Frequenzsignaturen, welche den einzelnen Clustern 26-28 zugeordnet werden können, können somit Teilentladungsquellen auf einfache Art und Weise von der Verarbeitungseinheit 21 identifiziert werden. Darüber hinaus können Ausgaben, welche vergleichbar zu der Ausgabe der Fig. 5 sind, für jeden der Cluster 26-28 separat von der Verarbeitungseinheit 21 bereitgestellt werden. Dadurch ist eine detailliertere Analyse der unterschiedlichen Störquellen und ihren Einfluss auf die Gesamtqualität des Prüflings 10 möglich.

Obwohl, wie bereits zuvor beschrieben, mit Hilfe der Filter 18-20 Störsignale, welche am Messpunkt 16 erfasst werden, weitestgehend herausgefiltert werden können, können dennoch Störsignale beispielsweise im Durchlassbereich der Filter 18-20 vorhanden sein, welche somit von den Filtern 18-20 nicht beseitigt werden können. Diese Störungen, beispielsweise leitungsgebundene Störungen von der Versorgungsspannung V oder elektromagnetische Störungen von Radiosendern oder elektrischen Maschinen oder elektrischen Leitungen in der Umgebung des Prüflings 10, führen in dem Abbildungsraum 22 ebenfalls zu Häufungen oder Clustern, da diese Störungen typischerweise auch jeweils eine charakteristische Frequenzsignatur aufweisen. Mit Hilfe der Clusteranalyse kann die Verarbeitungseinheit 21 derartige Häufungen als Störungen identifizieren und bei der Berechnung einer gesamten Teilentladung des Prüflings 10 unberücksichtigt lassen, indem die entsprechenden vermeintlichen gefilterten Teilentladungssignale unberücksichtigt bleiben. Dadurch kann die Messgenauigkeit gegenüber der Teilentladungsmessvorrichtung gemäß dem Stand der Technik (Fig. 4) erheblich verbessert werden.

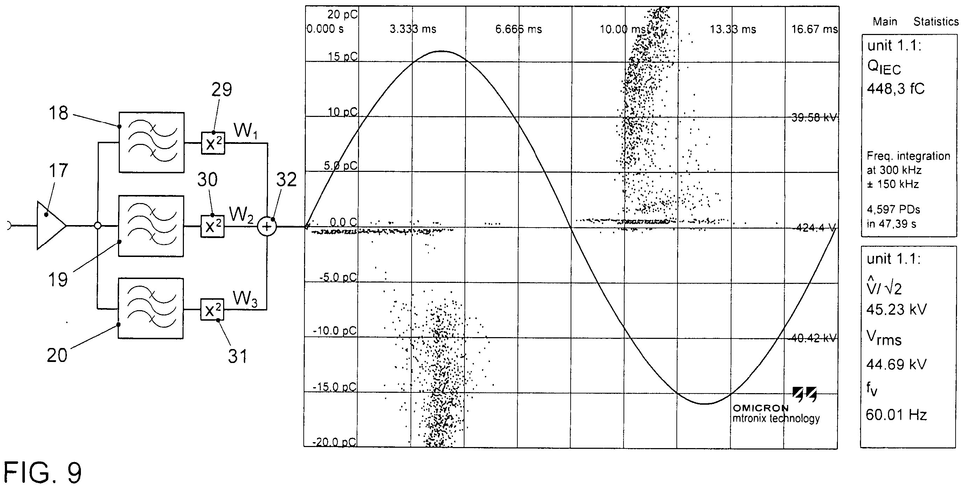

Neben der im Zusammenhang mit Fig. 7 und 8 beschriebenen Clusteranalyse führt die Verarbeitungseinheit 21 eine weitere Verarbeitung der gefilterten Teilentladungssignale von den Filtern 18-20 durch. Diese weitere Verarbeitung wird nachfolgend im Zusammenhang mit Fig. 9 beschrieben werden. Fig. 9 zeigt zunächst wiederum den Verstärker 17 und die Filter 18-20, wie sie im bereits im Zusammenhang mit Fig. 6 und 7 beschrieben wurden. Wie in Fig. 9 gezeigt, werden nun die Ausgaben der Filter 18-20 zunächst jeweils mit Hilfe von Quadrierern 29-31 quadriert und dann jeweils mit einem Gewichtungsfaktor W₁, W₂ bzw. W₃ multipliziert, und schließlich mit Hilfe eines Addierers 32 zu einem gefilterten Gesamtteilentladungssignal addiert. Das Quadrieren der Ausgaben der Filter 18-20 mit Hilfe der Quadrierer 29-31 dient im Wesentlichen dazu, einen Betragswert der Filterausgaben bereitzustellen. Da die Filterausgaben üblicherweise komplexe Werte umfassen, kann mit Hilfe der Quadrierer 29-31 auf einfache Art und Weise ein reeller Betragswert bereitgestellt werden. Untersuchungen haben ergeben, dass für die oben genannten Durchlassbereiche der Filter 18-20 folgende Werte für die Gewichtungen W₁-W₃ besonders geeignet sind:
W₁=1,0
W₂=1,1
W₃=1,0.

Der Vorteil der in Fig. 9 gezeigten Filterstruktur und Weiterverarbeitung gegenüber dem Filter 2 gemäß dem Stand der Technik (Fig. 4), liegt in der Robustheit der erfindungsgemäßen Filterstruktur (Fig. 9) gegenüber Superpositions- oder Überlagerungseffekten mehrerer Teilentladungsquellen. Ein reales Filter, wie beispielsweise das in Fig. 4 gezeigte Bandpassfilter 2, kann, wenn es mit bestimmten Impulsmustern beaufschlagt wird, zu Schwingungen neigen und/oder Nullstellen aufweisen. Dies kann zu einer gegenseitigen Auslöschung oder Abschwächung oder Überlagerung von zwei oder mehreren Teilentladungsimpulsen führen. Dieses Problem tritt insbesondere bei Teilentladungsmessungen an Kabeln auf. Hier kann eine Auslöschung, eine so genannten negative Superposition, durch eine Überlagerung eines Originalteilentladungsimpulses mit einem am Kabelende reflektierten Teilentladungsimpuls kommen. Bei bestimmten Kabellängen führt dies zu einer negativen Überlagerung oder sogar Auslöschung in deren Folge ein Teilentladungsfehler am Kabel nicht festgestellt wird. Durch die Verwendung der Filterstruktur der Fig. 9 kann diese negative Superposition vermieden werden. Selbst wenn eines der Filter 18-20 aufgrund seiner Eigenschaften eine negative Superposition eines Originalteilentladungsimpulses mit dem am Ende reflektierten Impuls aufweist und somit kein gefiltertes Teilentladungssignal ausgibt, geben die beiden anderen Filter der Filterstruktur 18-20 jeweils ein gefiltertes Teilentladungssignal aus, da ihre Filtercharakteristiken unterschiedlich sind. Somit wird die gesamte Teilentladungsmessvorrichtung erheblich robuster gegenüber diesem negativen Superpositionsphänomen.

Da sowohl die Clusteranalyse, welche im Zusammenhang mit Fig. 7 und 8 beschrieben wurde, als auch die gewichtete Summenbildung, welche im Zusammenhang mit Fig. 9 beschrieben wurde, auf der parallelen Filterung des Teilentladungsimpulses mit Hilfe der Filter 18-20 beruht, können die beiden Verfahren auf einfache Art und Weise in einer Verarbeitungseinheit 21 kombiniert werden, um eine Teilentladungsmessung durchzuführen, welche sowohl robust gegenüber Störquellen als auch robust gegenüber der oben beschriebenen negativen Superposition ist. Darüber hinaus kann mit Hilfe der Clusteranalyse eine verbesserte Identifikation von Teilentladungsstörquellen bereitgestellt werden.

Die zuvor beschriebenen Verfahren und Vorrichtungen können in analoger Schaltungstechnik, in digitaler Schaltungstechnik, z.B. mit Hilfe eines oder mehrerer Mikroprozessoren, oder in einer Kombination von analoger und digitaler Schaltungstechnik ausgeführt werden.

### BEZUGSZEICHENLISTE

- 1: Verstärker
- 2: Filter
- 3: gefiltertes Teilentladungssignal
- 4: Anzeige der Teilentladungen
- 5: Speisespannung
- 6: Teilentladung
- 10: elektrische Komponente
- 11: Teilentladungsmessvorrichtung
- 12: Zuleitung
- 13: Masse
- 14: Koppelkondensator
- 15: Messimpedanz
- 16: Messpunkt
- 17: Verstärker
- 18-20: Filter
- 21: Verarbeitungseinheit
- 22: Abbildungsraum
- 23-25: Raumachse
- 26-28: Häufungspunkt, Cluster
- 29-31: Quadrierer
- 32: Addierer

## Patentansprüche

1. Verfahren zum Bestimmen von Teilentladungen an einer elektrischen Komponente, umfassend die Schritte:
- Erfassen eines elektrischen Signals, welches Teilentladungsimpulse aufgrund der Teilentladungen (6) an der elektrischen Komponente (10) umfasst,
- Erzeugen von n gefilterten Teilentladungssignalen durch Filtern des elektrischen Signals mit n Filtern (18-20) mit n unterschiedlichen Filtercharakteristiken, wobei jeweils eines der gefilterten Teilentladungssignale jeweils einem der n Filter (18-20) zugeordnet ist, wobei n größer oder gleich 2 ist,
- Bilden eines jeweiligen n-Tupels pro Teilentladungsimpuls, wobei Werte des n-Tupels den n gefilterten Teilentladungssignalen des Teilentladungsimpulses entsprechen, und
- Bestimmen von Teilentladungssignaturen der Teilentladungen (6) durch Verknüpfen der n gefilterten Teilentladungssignale, wobei das Verknüpfen eine Clusteranalyse der n-Tupel umfasst.

2. Verfahren nach Anspruch 1, **dadurch gekennzeichnet, dass** eine Teilentladungsquelle, welche eine Teilentladung (6) in der elektrischen Komponenten (10) bewirkt, anhand mindestens eines Clusters (26-28) der Clusteranalyse identifiziert wird.

3. Verfahren nach einem der Ansprüche 1 oder 2, **dadurch gekennzeichnet,**
**dass** das elektrische Signal ferner Störsignale umfasst, welche von einer Störquelle innerhalb oder außerhalb der elektrischen Komponente (10) erzeugt werden und als gefilterte Teilentladungssignale von den n Filtern (18-20) bereitgestellt werden,
**dass** die Störquelle anhand mindestens eines Clusters (26-28) der Clusteranalyse identifiziert wird, und
**dass** zum Bestimmen der Teilentladungen (6) der elektrischen Komponente (10) nur gefilterte Teilentladungssignale verwendet werden, welche nicht von der Störquelle erzeugt wurden.

4. Verfahren nach einem der Ansprüche 1-3, **dadurch gekennzeichnet, dass** das Verknüpfen ein Bestimmen eines Betrags von jedem der n gefilterten Teilentladungssignale und ein gewichtetes Addieren der Beträge der n gefilterten Teilentladungssignale umfasst.

5. Verfahren nach Anspruch 4, **dadurch gekennzeichnet,**
**dass** ein erstes der n Filter ein Bandpassfilter (18) mit einem Durchlassbereich von ca. 82-243 kHz ist, ein zweites der n Filter ein Bandpassfilter (19) mit einem Durchlassbereich von ca. 227-387 kHz ist und ein drittes der n Filter ein Bandpassfilter (20) mit einem Durchlassbereich von ca. 377-537 kHz ist, und
**dass** ein erster Gewichtungsfaktor (W₁) zum gewichteten Addieren des von dem ersten Filter (18) gefilterten Teilentladungssignals den Wert 1 hat, ein zweiter Gewichtungsfaktor (W₂) zum gewichteten Addieren des von dem zweiten Filter (19) gefilterten Teilentladungssignals den Wert 1,1 hat und ein dritter Gewichtungsfaktor (W₃) zum gewichteten Addieren des von dem dritten Filter (20) gefilterten Teilentladungssignals den Wert 1 hat.

6. Verfahren nach einem der Ansprüche 1-5, **dadurch gekennzeichnet, dass** n=3 gilt.

7. Verfahren nach einem der Ansprüche 1-6, **dadurch gekennzeichnet, dass** die elektrische Komponente (10) ein Hochspannungskabel, einen Transformator, einen elektrischen Generator oder eine elektrische Antriebsmaschine umfasst.

8. Vorrichtung zum Bestimmen von Teilentladungen an einer elektrischen Komponente, umfassend
- einen Eingangsanschluss (16) zum Koppeln der Vorrichtung (11) mit der elektrischen Komponente (10), wobei der Vorrichtung (11) über den Eingangsanschluss ein elektrisches Signal von der elektrischen Komponente (10) zuführbar ist, welches Teilentladungsimpulse aufgrund der Teilentladungen (6) an der elektrischen Komponente (10) umfasst,
- n Filter (18-20), welche eingangsseitig mit dem Eingangsanschluss (16) gekoppelt sind, und ausgestaltet sind, ausgangseitig n gefilterte Teilentladungssignale in Abhängigkeit des elektrischen Signals bereitzustellen, wobei die n Filter (18-20) n unterschiedliche Filtercharakteristiken aufweisen, wobei n größer oder gleich 2 ist, und
- eine Verarbeitungseinheit (21), welche mit den Ausgängen der n Filter (18-20) gekoppelt ist,
wobei die Verarbeitungseinheit (21) ausgestaltet ist,
pro Teilentladungsimpuls ein n-Tupel zu bilden, wobei Werte des n-Tupels den n gefilterten Teilentladungssignalen des Teilentladungsimpulses entsprechen, und
Teilentladungssignaturen der Teilentladungen (6) durch Verknüpfen der n gefilterten Teilentladungssignale zu bestimmen, wobei die Verarbeitungseinheit (21) zum Verknüpfen der n gefilterten Teilentladungssignale eine Clusteranalyseeinheit umfasst, welche ausgestaltet ist, Cluster (26-28) von Teilentladungsimpulsen mittels einer Clusteranalyse von mehreren n-Tupeln von mehreren Teilentladungsimpulsen zu bestimmen.

9. Vorrichtung nach Anspruch 8, **dadurch gekennzeichnet, dass** die Verarbeitungseinheit (21) ausgestaltet ist, mit Hilfe der Cluster (26-28) der Clusteranalyseeinheit eine Teilentladungsquelle, welche eine Teilentladung (6) an der elektrischen Komponenten (10) bewirkt, anhand mindestens eines Clusters (26-28) zu identifizieren.

10. Vorrichtung nach einem der Ansprüche 8 oder 9, **dadurch gekennzeichnet, dass** das elektrische Signal ferner Störsignale umfasst, welche von einer Störquelle innerhalb oder außerhalb der elektrischen Komponente (10) erzeugt werden und als gefilterte Teilentladungssignale von den n Filtern (18-20) bereitgestellt werden,
dass die Verarbeitungseinheit (21) ausgestaltet ist, mit Hilfe der Cluster (26-28) der Clusteranalyseeinheit die Störquelle anhand mindestens eines Clusters (26-28) zu identifizieren, und
dass die Verarbeitungseinheit (21) ausgestaltet ist, die Teilentladungen (6) der elektrischen Komponente (10) zu bestimmen, indem sie nur gefilterte Teilentladungssignale verwendet, welche nicht von der Störquelle erzeugt wurden.

11. Vorrichtung nach einem der Ansprüche 8-10, **dadurch gekennzeichnet, dass** die Verarbeitungseinheit (21) ausgestaltet ist,
n Beträge der n gefilterten Teilentladungssignale zu bestimmen,
die n Beträge jeweils mit einem eigenen Gewichtungsfaktor (W₁-W₃) zu multiplizieren, und
die gewichteten Beträge zu summieren, um daraus den Betrag einer Teilentladung (6) der elektrischen Komponente zu bestimmen.

12. Vorrichtung nach Anspruch 11, **dadurch gekennzeichnet,**
**dass** ein erstes der n Filter ein Bandpassfilter (18) mit einem Durchlassbereich von ca. 82-243 kHz ist, ein zweites der n Filter ein Bandpassfilter (19) mit einem Durchlassbereich von ca. 227-387 kHz ist und ein drittes der n Filter ein Bandpassfilter (20) mit einem Durchlassbereich von ca. 377-537 kHz ist, und
**dass** ein erster Gewichtungsfaktor (W₁) zum gewichteten Addieren des von dem ersten Filter (18) gefilterten Teilentladungssignals den Wert 1 hat, ein zweiter Gewichtungsfaktor (W₂) zum gewichteten Addieren des von dem zweiten Filter (19) gefilterten Teilentladungssignals den Wert 1,1 hat, und ein dritter Gewichtungsfaktor (W₃) zum gewichteten Addieren des von dem dritten Filter (20) gefilterten Teilentladungssignals den Wert 1 hat.

13. Vorrichtung nach einem der Ansprüche 8-12, **dadurch gekennzeichnet, dass** n=3 gilt.

14. Vorrichtung nach einem der Ansprüche 8-13, **dadurch gekennzeichnet, dass** die Vorrichtung (10) ferner einen Koppelkondensator (14) und eine Messimpedanz (15) umfasst,
wobei der Koppelkondensator (14) den Eingangsanschluss (16) mit einer Spannungsversorgung (V) der elektrischen Komponenten (10) koppelt, und
wobei die Messimpedanz (15) den Eingangsanschluss (16) mit einer Masse (13) der elektrischen Komponente (10) koppelt.

15. Vorrichtung nach einem der Ansprüche 8-14, **dadurch gekennzeichnet, dass** jedes der n Filter (18-20) derart ausgestaltet ist, dass das gefilterte Teilentladungssignal proportional zu einer Ladung der entsprechenden Teilentladung (6) ist.

16. Vorrichtung nach einem der Ansprüche 8-15, **dadurch gekennzeichnet, dass** die elektrische Komponente (10) ein Hochspannungskabel, einen Transformator, einen elektrischen Generator oder eine elektrische Antriebsmaschine umfasst.

## Claims

1. Method for determining partial discharges in an electrical insulation system of an electrical component, comprising the steps:
- detecting an electrical signal that comprises partial discharge pulses due to the partial discharge (6) at the electrical component (10),
- generating n filtered partial discharge signals by filtering the electrical signal by means of n filters (18-20) having n different filter characteristics, respectively one of the filtered partial discharge signals being assigned, respectively, to one of the n filters (18-20), n being greater than or equal to 2,
- forming a respective n-tuple per partial discharge pulse, values of the n-tuple corresponding to the n filtered partial discharge signals of the partial discharge pulse, and
- determining partial discharge signatures of the partial discharges (6) by linking the n filtered partial discharge signals, the linking comprising a cluster analysis of the n-tuples.

2. Method according to claim 1, **characterized in that** a partial discharge source that causes a partial discharge (6) in the electrical component (10) is identified on the basis of at least one cluster (26-28) of the cluster analysis.

3. Method according to claims 1 or claim 2, **characterized in that**
the electrical signal further comprises disturbance signals that are generated by a disturbance source inside or outside the electrical component (10) and that are provided, as filtered partial discharge signals, by the n filters (18-20),
the disturbance source is identified on the basis of at least one cluster (26-28) of the cluster analysis, and
only filtered partial discharge signals that were not generated by the disturbance source are used to determine the partial discharges (6) of the electrical component (10).

4. Method according to any one of claims 1-3, **characterized in that** the linking comprises determining an amount of each of the n filtered partial discharge signals, and weighted adding of the amounts of the n filtered partial discharge signals.

5. Method according to claim 4, **characterized in that**
a first of the n filters is a bandpass filter (18) having a passband range of approximately 82-243 kHz, a second of the n filters is a bandpass filter (19) having a passband range of approximately 227-387 kHz, and a third of the n filters is a bandpass filter (20) having a passband range of approximately 377-537 kHz, and
a first weighting factor (W₁) for the weighted adding of the partial discharge signal filtered by the first filter (18) has the value 1, a second weighting factor (W₂) for the weighted adding of the partial discharge signal filtered by the second filter (19) has the value 1.1, and a third weighting factor (W₃) for the weighted adding of the partial discharge signal filtered by the third filter (20) has the value 1.

6. Method according to any one of claims 1-5, **characterized in that** n=3.

7. Method according to any one of claims 1-6, **characterized in that** the electrical component (10) comprises a high-voltage cable, a transformer, an electrical generator or an electrical drive machine.

8. Device for determining partial discharges at an electrical component, comprising
- an input terminal (16) for coupling the device (11) to the electrical component (10), an electrical signal from the electrical component (10), which signal comprises partial discharge pulses resulting from the partial discharges (6) at the electrical component (10), being able to be supplied to the device (11) via the input terminal,
- n filters (18-20) that are coupled, on the input side, to the input terminal (16) and are designed to provide, on the output side, n filtered partial discharge signals in dependence on the electrical signal, the n filters (18-20) having n different filter characteristics, n being greater than or equal to 2, and
- a processing unit (21) that is coupled to the outputs of the n filers (18-20),
the processing unit (21) being designed
to form an n-tuple per partial discharge pulse, values of the n-tuple corresponding to the n filtered partial discharge signals of the partial discharge pulse, and
to determine partial discharge signatures of the partial discharges (6) by linking the n filtered partial discharge signals, the processing unit (21) comprising a cluster analysis unit for the linking of the n filtered partial discharge signals, which is designed to determine clusters (26-28) of partial discharge pulses by means of a cluster analysis of a plurality of n-tuples of a plurality of partial discharge pulses.

9. Device according to claim 8, **characterized in that** the processing unit (21) is designed to use the clusters (26-28) of the cluster analysis unit to identify, on the basis of at least one cluster (26-28), a partial discharge source that causes a partial discharge (6) at the electrical component (10).

10. Device according to claims 8 or claim 9, **characterized in that**
the electrical signal further comprises disturbance signals that are generated by a disturbance source inside or outside the electrical component (10) and that are provided, as filtered partial discharge signals, by the n filters (18-20),
the processing unit (21) is designed to use the clusters (26-28) of the cluster analysis unit to identify the disturbance source on the basis of at least one cluster (26-28), and
the processing unit (21) is designed to determine the partial discharges (6) of the electrical component (10) **in that** it uses only filtered partial discharge signals that were not generated by the disturbance source.

11. Device according to any one of claims 8-10, **characterized in that**
the processing unit (21) is designed
to determine n amounts of the n filtered partial discharge signals,
to multiply each of the n amounts by a weighting factor (W₁-W₃) of its own, and
to add the weighted amounts, in order to determine therefrom the amount of a partial discharge (6) of the electrical component.

12. Device according to claim 11, **characterized in that**
a first of the n filters is a bandpass filter (18) having a passband range of approximately 82-243 kHz, a second of the n filters is a bandpass filter (19) having a passband range of approximately 227-387 kHz, and a third of the n filters is a bandpass filter (20) having a passband range of approximately 377-537 kHz, and
a first weighting factor (W₁) for the weighted adding of the partial discharge signal filtered by the first filter (18) has the value 1, a second weighting factor (W₂) for the weighted adding of the partial discharge signal filtered by the second filter (19) has the value 1.1, and a third weighting factor (W₃) for the weighted adding of the partial discharge signal filtered by the third filter (20) has the value 1.

13. Device according to any one of claims 8-12, **characterized in that** n=3.

14. Device according to any one of claims 8-13, **characterized in that** the device (10) further comprises a coupling capacitor (14) and a measuring impedance (15),
the coupling capacitor (14) coupling the input terminal (16) to a voltage supply (V) of the electrical component (10), and the measuring impedance (15) coupling the input terminal (16) to an earth (13) of the electrical component (10).

15. Device according to any one of claims 8-14, **characterized in that** each of the n filters (18-20) is designed in such a way that the filtered partial discharge signal is proportional to a charge of the corresponding partial discharge (6).

16. Device according to any one of claims 8-15, **characterized in that** the electrical component (10) comprises a high-voltage cable, a transformer, an electrical generator or an electrical drive machine.

## Revendications

1. Procédé servant à déterminer des déchargements partiels au niveau d'un composant électrique, comprenant les étapes consistant à :
- détecter un signal électrique, qui comprend des impulsions de déchargement partiel du fait des déchargements partiels (6) au niveau du composant électrique (10),
- générer n signaux de déchargement partiel filtrés en filtrant le signal électrique avec n filtres (18 - 20) avec n caractéristiques de filtre différentes, dans lequel respectivement un des signaux de déchargement partiel filtrés est associé respectivement à l'un des n filtres (18 - 20), dans lequel n est supérieur ou égal à 2,
- obtenir un n-uplet respectif par impulsion de déchargement partiel, dans lequel des valeurs du n-uplet correspondent aux n signaux de déchargement partiel filtrés de l'impulsion de déchargement partiel, et
- déterminer des signatures de déchargement partiel des déchargements partiels (6) en combinant les n signaux de déchargement partiel filtrés, dans lequel la combinaison comprend une analyse par grappes des n-uplets.

2. Procédé selon la revendication 1, **caractérisé en ce qu'**une source de déchargement partiel, qui entraîne un déchargement partiel (6) dans le composant électrique (10), est identifiée à l'aide d'au moins une grappe (26 - 28) de l'analyse par grappes.

3. Procédé selon l'une quelconque des revendications 1 ou 2, **caractérisé en ce**
**que** le signal électrique comprend en outre des signaux parasites, qui sont générés par une source parasite à l'intérieur ou à l'extérieur du composant électrique (10) et qui sont fournis en tant que signaux de déchargement partiel filtrés par les n filtres (18 - 20),
**que** la source parasite est identifiée à l'aide d'au moins une grappe (26 - 28) de l'analyse par grappes, et
**qu'**afin de déterminer les déchargements partiels (6) du composant électrique (10), des signaux de déchargement partiel filtrés sont seulement utilisés, lesquels n'ont pas été générés par la source parasite.

4. Procédé selon l'une quelconque des revendications 1 - 3, **caractérisé en ce que** la combinaison comprend une détermination d'un montant pour chacun des n signaux de déchargement partiel filtrés et un ajout pondéré des montants des n signaux de déchargement partiel filtrés.

5. Procédé selon la revendication 4, **caractérisé en ce**
**qu'**un premier filtre des n filtres est un filtre passe-bande (18) avec une bande passante d'environ 82 - 243 kHz, un deuxième des n filtres est un filtre passe-bande (19) avec une bande passante d'environ 227 - 387 kHz, et un troisième des n filtres est un filtre passe-bande (20) avec une bande passante d'environ 377 - 537 kHz, et
**qu'**un premier facteur de pondération (W₁) servant à ajouter de manière pondérée le signal de déchargement partiel filtré par le premier filtre (18) a la valeur 1, un deuxième facteur de pondération (W₂) servant à ajouter de manière pondérée le signal de déchargement partiel filtré par le deuxième filtre (19) a la valeur 1,1, et un troisième facteur de pondération (W₃) servant à ajouter de manière pondérée le signal de déchargement partiel filtré par le troisième filtre (20) a la valeur 1.

6. Procédé selon l'une quelconque des revendications 1 - 5, **caractérisé en ce que** s'applique n = 3.

7. Procédé selon l'une quelconque des revendications 1 - 6, **caractérisé en ce que** le composant électrique (10) comprend un câble à haute tension, un transformateur, un générateur électrique ou une machine d'entraînement électrique.

8. Dispositif servant à déterminer des déchargements partiels au niveau d'un composant électrique, comprenant
- une borne d'entrée (16) servant à coupler le dispositif (11) au composant électrique (10), dans lequel un signal électrique provenant du composant électrique (10) peut être amené au dispositif (11) par l'intermédiaire de la borne d'entrée, lequel comprend des impulsions de déchargement partiel du fait des déchargements partiels (6) au niveau du composant électrique (10),
- n filtres (18 - 20), qui sont couplés du côté de l'entrée à la borne d'entrée (16) et qui sont configurés pour fournir du côté de la sortie n signaux de déchargement partiel filtrés en fonction du signal électrique, dans lequel les n filtres (18 - 20) présentent n caractéristiques de filtre, dans lequel n est supérieur ou égal à 2, et
- une unité de traitement (21), qui est couplée aux sorties des n filtres (18 - 20),
dans lequel l'unité de traitement (21) est configurée
pour former par impulsion de déchargement partiel un n-uplet, dans lequel des valeurs du n-uplet correspondent aux n signaux de déchargement partiel filtrés de l'impulsion de déchargement partiel, et
pour déterminer des signatures de déchargement partiel des déchargements partiels (6) en combinant les n signaux de déchargement partiel filtrés, dans lequel l'unité de traitement (21) servant à combiner les n signaux de déchargement partiel filtrés comprend une unité d'analyse par grappes, qui est configurée pour déterminer des grappes (26 - 28) d'impulsions de déchargement partiel au moyen d'une analyse par grappes de plusieurs n-uplets de plusieurs impulsions de déchargement partiel.

9. Dispositif selon la revendication 8, **caractérisé en ce que** l'unité de traitement (21) est configurée pour identifier à l'aide des grappes (26 - 28) de l'unité d'analyse par grappes une source de déchargement partiel, qui entraîne un déchargement partiel (6) au niveau du composant électrique (10), à l'aide d'au moins une grappe (26 - 28).

10. Dispositif selon l'une quelconque des revendications 8 ou 9, **caractérisé en ce**
**que** le signal électrique comprend en outre des signaux parasites, qui sont générés par une source parasite à l'intérieur ou à l'extérieur du composant électrique (10) et qui sont fournis en tant que signaux de déchargement partiel filtrés par les n filtres (18 - 20),
**que** l'unité de traitement (21) est configurée pour identifier à l'aide des grappes (26 - 28) de l'unité d'analyse par grappes la source parasite à l'aide d'au moins une grappe (26 - 28), et
**que** l'unité de traitement (21) est configurée pour déterminer les déchargements partiels (6) du composant électrique (10) en ce qu'elle n'utilise que des signaux de déchargement partiel filtrés, qui n'ont pas été générés par la source parasite.

11. Dispositif selon l'une quelconque des revendications 8 - 10, **caractérisé en ce que** l'unité de traitement (21) est configurée
pour déterminer n montants des n signaux de déchargement partiel filtrés,
pour multiplier les n montants respectivement par un facteur de pondération (W₁ - W₃) propre, et
pour additionner les montants pondérés afin de déterminer sur cette base le montant d'un déchargement partiel (6) du composant électrique.

12. Dispositif selon la revendication 11, **caractérisé en ce**
**qu'**un premier des n filtres est un filtre passe-bande (18) avec une bande passante d'environ 82 - 243 kHz, un deuxième filtre des n filtres est un filtre passe-bande (19) avec une bande passante d'environ 227 - 387 kHz et un troisième des n filtres est un filtre passe-bande (20) avec une bande passante d'environ 377 - 537 kHz, et
**qu'**un premier facteur de pondération (W₁) servant à ajouter de manière pondérée le signal de déchargement partiel filtré par le premier filtre (18) a la valeur 1, un deuxième facteur de pondération (W₂) servant à ajouter de manière pondérée le signal de déchargement partiel filtré par le deuxième filtre (19) a la valeur 1,1 et un troisième facteur de pondération (W₃) servant à ajouter de manière pondérée le signal de déchargement partiel filtré par le troisième filtre (20) a la valeur 1.

13. Dispositif selon l'une quelconque des revendications 8 - 12, **caractérisé en ce que** s'applique n = 3.

14. Dispositif selon l'une quelconque des revendications 8 - 13, **caractérisé en ce que** le dispositif (10) comprend en outre un condensateur de couplage (14) et une impédance de mesure (15),
dans lequel le condensateur de couplage (14) couple la borne d'entrée (16) à une alimentation en tension (V) du composant électrique (10), et
dans lequel l'impédance de mesure (15) couple la borne d'entrée (16) à une masse (13) du composant électrique (10).

15. Dispositif selon l'une quelconque des revendications 8 - 14, **caractérisé en ce que** chacun des n filtres (18 - 20) est configuré de telle manière que le signal de déchargement partiel filtré est proportionnel par rapport à une charge du déchargement partiel (6) correspondant.

16. Dispositif selon l'une quelconque des revendications 8 - 15, **caractérisé en ce que** le composant électrique (10) comprend un câble à haute tension, un transformateur, un générateur électrique ou une machine d'entraînement électrique.
